## Europäisches Patentamt

(19) European Patent Office

Office européen des brevets

(11) Veröffentlichungsnummer: **0 284 854 B1**

(12) **EUROPÄISCHE PATENTSCHRIFT**

(45) Veröffentlichungstag der Patentschrift:
02.05.91 Patentblatt 91/18

(51) Int. Cl.$^5$: **C23C 30/00, C23C 14/02, C23C 14/06**

(21) Anmeldenummer: 88103809.5

(22) Anmeldetag: 10.03.88

(54) Mischnitrid-Schichten mit wenigstens zwei Metallen und Verfahren zu deren Herstellung.

(30) Priorität: 23.03.87 DE 3709468

(43) Veröffentlichungstag der Anmeldung:
05.10.88 Patentblatt 88/40

(45) Bekanntmachung des Hinweises auf die Patenterteilung:
02.05.91 Patentblatt 91/18

(84) Benannte Vertragsstaaten:
AT BE CH DE ES FR GB GR IT LI LU NL SE

(56) Entgegenhaltungen:
EP-A- 0 038 294
AU-A- 538 944
FR-A- 2 156 413
FR-A- 2 557 562
GB-A- 2 117 009
US-A- 4 060 471
JOURNAL OF THE ELECTROCHEMICAL SOCIETY, Band 118, Nr. 11, November 1971, Seiten 1856-1862, Princetown, New Jersey, US; L.D. LOCKER et al.: "Preparation of hafnium-tantalum nitride films by reactive alloy sputtering"
JOURNAL VAC. SCI. TECHNOLOG., Band A4, Nr. 6, November/Dezember 1986, Seiten 2695-2700, American Vacuum Society, New York, US; O. KNOTEK et al.: "On structure and properties of sputtered Ti and Al based hard compound films"
JOURNAL VAC. SCI. TECHNOLOG., Band A4, Nr. 6, November/Dezember 1986, Seiten 2701-2705, American Vacuum Society, New York, US; A.J. HERMANN et al.: "Morphology and properties of sputtered (Ti,Al)N layers on high speed steel substrates as a function of deposition temperature and sputtering atmosphere"
THIN SOLID FILMS, Band 97, Nr. 1, November 1982, Seiten 69-77, Elsevier Sequoia, NL; J.M. POITEVIN et al.: "Influence of substrate bias on the composition, structure and electrical properties of reactively sputtered TiN films"

(56) Entgegenhaltungen:
PATENT ABSTRACTS OF JAPAN, Band 8, Nr. 98 (C-221)[1535], 9. Mai 1984; & JP-A-59 13 608
IBM TECHNICAL DISCLOSURE BULLETIN, Band 24, Nr. 6, November 1981, Seiten 2962-2963, New York, US; P.H. SMITH: "Method of varying composition of multi-component sputtered films"

(73) Patentinhaber: Siemens Aktiengesellschaft
Wittelsbacherplatz 2
W-8000 München 2 (DE)

(72) Erfinder: Freller, Helmut
Steinbergstrasse 34a
W-8505 Röthenbach/P. (DE)
Erfinder: Schack, Peter
Schnieglingerstrasse 33
W-8500 Nürnberg (DE)

## Beschreibung

Die Erfindung bezieht sich auf ein Verfahren zur Herstellung von Mischnitrid-Schichten mit wenigstens zwei Metallen, insbesondere zur Beschichtung von extrem belasteten Werkzeugen und Produktkomponenten, wobei die Metalle einen deutlich unterschiedlichen Schmelzpunkt haben und wobei die Herstellung der Schichten durch Verdampfen von Kathoden aus vorgegebenen Ausgangslegierungen der Metalle im Lichtbogen unter gleichzeitiger Zuführung von Stickstoff als Reaktionsgas und durch Kondensieren auf einem Substrat erfolgt. Daneben bezieht sich die Erfindung auf nach diesem Verfahren hergestellte Mischnitrid-Schichten speziell mit Titan und Aluminium sowie Titan, Vanadium und Aluminium als Nitridbildner.

Die Anwendung bekannter PVD-Beschichtungsverfahren (physical vapour deposition) zum Verschleißschutz an Werkzeugen hat bisher bemerkenswerte Erfolge gehabt. Das heute weitgehend technisch für diese Anwendungszwecke beherrschte Schichtsystem, nämlich TiN, ist allerdings noch nicht geeignet, eine Lösung für alle Verschleißprobleme zu bieten. Die Zahl der Hartstoffe mit vergleichbaren Härtewerten ist außerordentlich groß. Da diese Hartstoffe teils metallischen, kovalenten oder ionischen Bindungscharakter haben, sind sie bezüglich ihrer chemischen, elektrischen, thermischen und/oder mechanischen Eigenschaften im allgemeinen sehr unterschiedlich. In vielen Fällen sind die bekannten Hartstoffe auch kombinierbar oder sogar mischbar.

Insbesondere Mischschichten oder Mehrlagenschichten würden innerhalb einer einzigen Schicht von wenigen µm eine Arbeitsteilung erlauben zwischen der Schichtoberfläche, die möglichst hart und gegen den bearbeiteten Werkstoff oder das angrenzende Medium bei der Arbeitstemperatur chemisch beständig sein muß, und der an den Trägerwerkstoff angrenzenden Schicht, die eine hohe chemische Affinität zu diesem Werkstoff und vergleichbaren thermischen Ausdehnungskoeffizienten und E-Modul aufweisen sollte, um eine optimale Haftfestigkeit auch unter Belastung zu ermöglichen.

Aus der AU-B-54637/80 sind sogenannte CERMET-Beschichtungen auf Substraten in der Anwendung für Solarzellen bekannt, die aus einem Zwei-Komponenten-Material mit einer keramikähnlichen Phase einerseits und einer metallähnlichen Phase andererseits bestehen. Diese Zwei-Komponenten-Materialien können gegebenenfalls eine Konzentrationsänderung der Komponenten innerhalb der Schicht aufweisen, wobei die Herstellung über reaktive Sputter-Prozesse mit mehreren Targets erfolgt, was im wesentlichen dem bereits angegebenen PVD-Verfahren entspricht. Allerdings handelt es sich bei den so hergestellten Schichten, bei denen gegebenenfalls als eine der beiden Komponenten ein hochschmelzendes Metall wie titan oder Vanadium ist und als Nitridbildner verwendet wird, nicht um Verschleißschutzschichten, sondern um optische Filter mit selektivem Absorptions- und Reflexionsverhalten.

Mit Hilfe der CVD-Verfahren (chemical vapour deposition) ist die Herstellung von abgestuften Verschleißschutzschichten bereits großtechnisch für die Beschichtung von Hartmetallwendeschneidplatten im Einsatz. Bei diesem Verfahren wird die Schichtkonzentration über eine Konzentrationsänderung der verwendeten Gase beeinflußt, wobei allerdings mit vergleichsweise hohen Reaktionstemperaturen gearbeitet wird. Mit 1000°C sind jedoch die Arbeitstemperaturen für viele Präzisionsteile, insbesondere von solchen aus Werkzeugstählen, zu hoch, so daß die resultierenden Formänderungen eine breitere, allgemeine Anwendung ausschließen. Die bei niedrigen Temperaturen, d.h. zwischen 300 und 500°C eingesetzten PVD-Verfahren, insbesondere die Kathodenzerstäubungsverfahren, benötigen dagegen entweder für jede Konzentration eine Quelle mit abgestuften Legierungsanteilen oder aber eine Veränderung des zu beschichtenden Teils in seiner geometrischen Lage zu mehreren unterschiedlichen Materialquellen. Dies ist für eine praktische Realisierung ungeeignet.

Aufgabe der Erfindung ist es, hier Abhilfe zu schaffen. Es sollen Mischnitrid-Schichten geschaffen werden, die für unterschiedliche Bedürfnisse anpaßbar sind.

Die Aufgabe ist erfindungsgemäß dadurch gelöst, daß beim Verdampen der Ausgangslegierung eine variable Spannung an das Substrat angelegt und in Abhängigkeit von der Schichtdicke auf dem Substrat verändert wird. Dadurch kann die Konzentration der Metalle über die Schichtdicke kontinuierlich verändert werden. Insbesondere bei Verwendung von Titan und Aluminium sowie Titan, Vanadium und Aluminium als Nitridbildber lassen sich derartige Mischnitrid-Schichten beispielsweise in der variablen Konstitution $Ti_x Al_{1-x} N$ oder $Ti_x Al_{1-(x+y)} V_y N$ erstellen.

Die Erfindung geht von der an sich bekannten Verdampfung einer Kathode aus einer Ausgangslegierung in einer Lichtbogenquelle und der Kondensation auf dem Substrat aus, wobei jetzt aber das Substrat auf beliebige Potentiale bis zu etwa 400 V gegenüber der Legierungskathode gelegt wird. In bekannter Weise kann dabei die Verdampfung im reaktiven Modus stattfinden, wenn Stickstoff als Reaktionsgas zugeführt wird.

Mit der Erfindung werden Mischnitrid-Schichten mit zwei oder mehr Metallen realisiert. Werden solche Zwei- oder Drei-Komponenten-Legierungssysteme bei einem Druck von beispielsweise 1 Pa in Stickstoffatmosphäre verdampft, so zeigt sich zunächst der überraschende Effekt, daß die Metalle in der Schicht in veränderten Konzentrationen gegenüber der Ausgangslegierung zu finden sind. Insbesondere zeigt sich, daß das Verhältnis der Metalle von der Spannung am Substrat abhängig ist und zwar derart, daß das Metall mit niedri-

2

gem Schmelzpunkt mit zunehmender negativer Substratspannung in seiner Konzentration abnimmt.

Letzterer erfindungsgemäßer Effekt war zunächst nicht zu erwarten, da die "flash"-artige Verdampfung aus dem schnell wandernden Kathodenfleck des Lichtbogens eigentlich eine gleichmäßige Verdampfung gewährleistet, was bei Substratpotentialen um 0 V auch tätsächlich bestätigt wurde. Im Rahmen der Erfindung wurde erkannt, daß der Grund für den Einfluß der Substratvorspannung in der unterschiedlichen Ionisierung der Metalle im Vakuumlichtbogen liegt. Während die vorwiegend positiven Metallionen vom negativ vorgespannten Substrat als Saugspannung angezogen werden, breiten sich die neutralen Dampfteilchen in einer Cosinus-Verteilung im Raum um den Verdampfer aus und werden von der Substratspannung nicht beeinflußt. Da der Ionenanteil bei Metallen mit hohem Schmelzpunkt höher ist als bei Metallen mit niedrigem Schmelzpunkt, hat die Substratspannung als Saugspannung unmittelbar Einfluß auf das Konzentrationsverhältnis der Metalle, sofern die Metalle einen unterschiedlichen Schmelzpunkt haben.

Weitere Einzelheiten und Vorteile der Erfindung zeigen sich an der nachfolgenden Beschreibung von Ausführungsbeispielen. Dazu wird auf die beigefügte Tabelle sowie auf grafische Darstellungen verwiesen. Es zeigen

FIG 1 den Verlauf der Aluminiumkonzentration bei drei verschiedenen Titan-Aluminium-Nitrid-Schichten in Abhängigkeit von der Substratspannung,

FIG 2 der Verlauf der Aluminium-, der Vanadium- und der Titan-Konzentration bei einer Titan-Aluminium-Vanadium-Nitrid-Schicht in Abhängigkeit von der Substratspannung und

FIG 3 und 4 Konzentrationsverläufe bei einem erfindungsgemäß beschichteten Werkzeug.

Zur Herstellung der Mischnitrid-Schichten wird ein bekanntes Vakuumsystem verwendet, bei dem Kathoden aus Metallegierungen im Lichtbogen verdampft werden. Gleichzeitig wird Stickstoff als reaktives Gas zugeführt, so daß die ionisierten Metallatome mit den Gasatomen reagieren können. An das Substrat ist eine zwischen 0 und –400 V variierbare Saugspannung anlegbar.

Es werden im allgemeinen Schichten von etwa 2 bis etwa 15 μm erzeugt. Die beschichteten Substratproben werden anschließend im einzelnen auf Oberflächenhärte, Abriebbeständigkeit und insbesondere auf Konzentrationsänderungen der Metalle über die Schichtdicke untersucht. Für letzteres werden bekannte Methoden angewandt, beispielsweise Mikrosonden-Untersuchungen Auger-Analyse oder GDOS-Verfahren (Glow Discharge Optical Spectroscopy).

Beispiel 1 : Herstellung von $Ti_xAl_{1-x}N$-Schichten

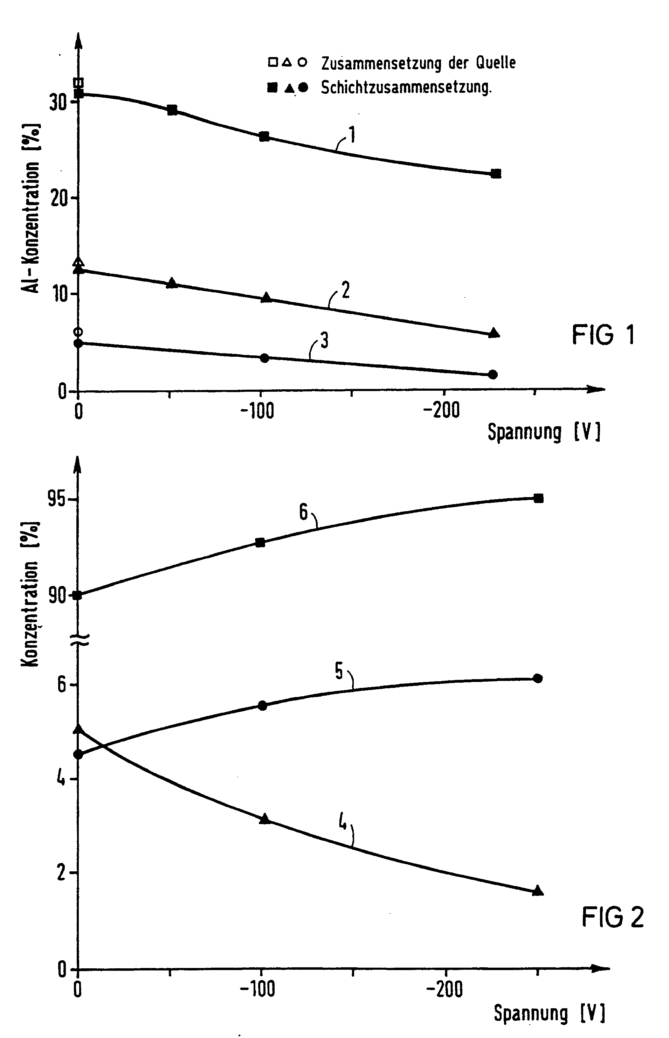

In FIG 1 sind die experimentellen Ergebnisse von drei Versuchsreihen dargestellt : Die Kurven repräsentieren jeweils den Aluminiumgehalt in Gew.% von Titan-Aluminium-Nitrid-Schichten. Dabei wurde Kurve 1 aus einer TiAl (32 Gew.% Al)-Legierung, Kurve 2 aus einer TiAl (13 Gew.% Al)-Legierung) und Kurve 3 aus einer TiAl (6 Gew.%)-Legierung erzeugt. Als Abszisse ist jeweils die Gegenspannung am Substrat zwischen Null und 250 V aufgetragen. In allen Fällen ergibt sich, daß der Aluminiumgehalt mit steigender Substratspannung deutlich abfällt, wobei der Abfall in etwa gleichwirkend verläuft. Bezogen auf die Ausgangskonzentration ergeben sich dabei relative Änderungen des Alumniumgehaltes zwischen 5 und 60%. Konkret läßt sich bei Kurve 1 von einer 30%igen Al-Ausgangskonzentration der Aluminiumgehalt auf etwa 25%, bei Kurve von einer 12%-Al-Ausgangskonzentration der Aluminiumgehalt auf etwa 9% und in Kurve 3 von einer 5%igen Ausgangskonzentration der Aluminiumgehalt auf etwa 2% erniedrigen. Entsprechend umgekehrt steigt der Titangehalt.

Beispiel 2 : Herstellung von $Ti_xAl_{1-(x+y)}V_y N$-Schichten

In einer FIG 1 entsprechenden Darstellung sind in FIG 2 die Aluminium-, Titan- und Vanadiumkonzentrationen für das Dreistoffsystem dargestellt. Dabei entspricht Kurve 4 im wesentlichen Kurve 3 aus FIG 1. Kurve 5 zeigt den sich mit der Gegenspannung ändernden Vanadium- und Kurve 6 den zugehörigen Titananteil. Aus FIG 2 ist erkennbar, daß – im Gegensatz zum abfallenden Aluminiumanteil – die Anteile an Vanadium und Titan ansteigen, was zu erwarten ist. Überraschend ist aber, daß der relative Anteil an Vanadium mit steigender Gegenspannung deutlich stärker als der Titananteil ansteigt. Es ist ersichtlich, daß sich speziell der kleinere Anteil prozentual stärker steigern läßt als der größere Basisanteil.

Durch Variation der Substratvorspannung bei der Herstellung lassen sich in Abhängigkeit von der Schichtdicke gezielte Konzentrationsänderungen der einzelnen Metalle erreichen. Letzteres ist im Beispiel 3 ausgeführt.

Beispiel 3 : Herstellung einer TiAlN-Schicht auf einem Stahlwerkzeug

Auf einem Eisen-Substrat soll eine Titan-Aluminium-Nitrid-Schicht mit geringer Aluminium-Konzentration im Bereich der Übergangszone Schicht/Substrat und ansteigender Konzentration in Richtung auf die Schichtoberfläche aufgebracht werden, wobei die Ergebnisse aus FIG 1 ausgewertet werden sollen. Die Verdampfungszeit im Lichtbogen wurde so gewählt, daß sich insgesamt eine Schichtdicke von etwa 8 µm ergibt. Die Mischnitridschicht wurde unter Verwendung zweier Materialquellen mit unterschiedlicher Aluminium-Konzentration hergestellt. Während der Beschichtung wurde zuerst eine Quelle mit einer relativ niedrigen Aluminium-Konzentration mit einer stufenweisen Veränderung der Substratspannung (zunächst 250 V, dann 50 V) betrieben. Anschließend wurde mit der Quelle mit einer höheren Aluminium-Konzentration der Rest der Schicht ebenfalls bei stufenweise veränderter Substratspannung (zunächst 250 V, dann 50 V) aufgebracht.

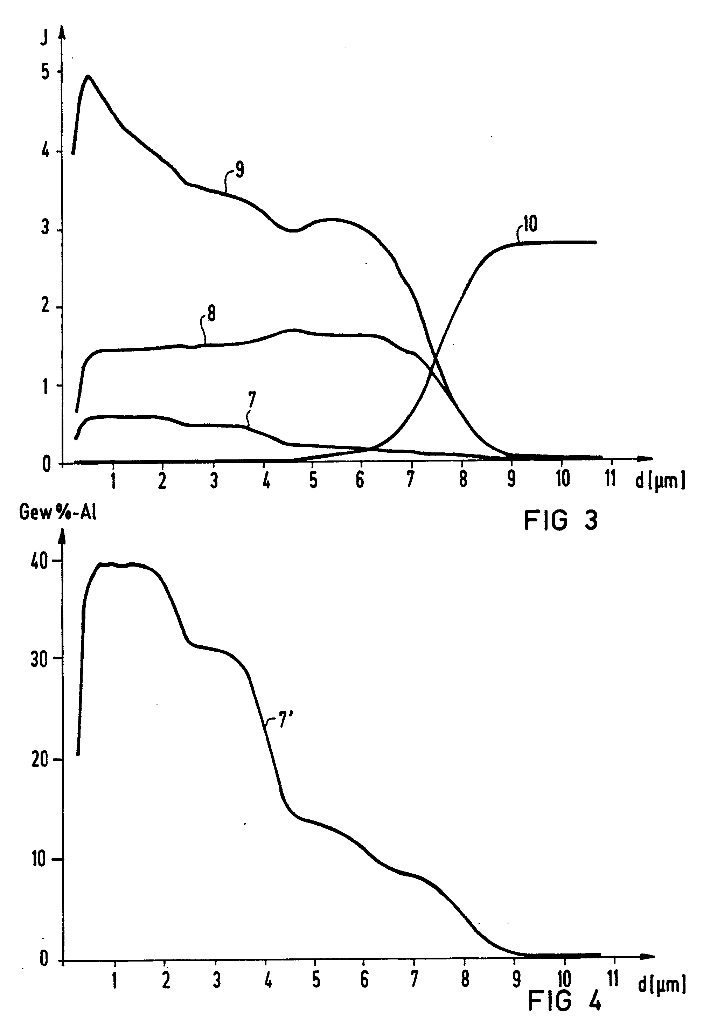

In FIG 3 ist eine Tiefenprofilanalyse der Einzelelemente Al, Ti und N einer sochen TiAIN-Schicht zusammen mit Fe des Substrates dargestellt. Die Analyse wurde mit GDOS (Glow Discharge Optical Spectroscopy) durchgeführt. Dabei zeigen die Kurven 7 bis 10 die relativen Intensitäten der Elemente Al, Ti, N und Fe. Speziell der Al-Intensitätsverlauf 7 ist in FIG 4 in Gew-% geeicht wiedergegeben.

Insbesondere der Aluminiumverlauf gemäß Kurve 7 in FIG 3 bzw. gemäß Kurve 7' in FIG 4 zeigt die im Beispiel 1 ermittelte Spannungsabhängigkeit. Die Spannungsstufen sind in der Tiefenprofilanalyse der Schicht eindeutig als Konzentrationsänderungen in Abhängigkeit von der Schichtdicke zu sehen.

Eine kontinuierliche Änderung der Substratvorspannung führt entsprechend zu allmählichen Konzentrationsänderungen. Ebenso können durch Springen zwischen zwei Substratspannungen MischnitridSchichten mit alternierender Aluminium-Konzentration in einem sandwichartigen Aufbau abgeschieden werden.

In der Praxis kann der Gradient der Metall-Konzentrationen in Abhängigkeit von der Problemstellung und der speziellen Anwendung des Werkzeuges bzw. der entsprechenden Produktkomponente definiert werden. So kann es beispielsweise sinnvoll sein, bei einer vorgegebenen Schichtdicke im ersten Drittel des Schichtbereiches ausgehend von der Substratoberfläche einen sehr starken Anstieg einer Metallkomponente zu erreichen und dann in dem verbleibenden Bereich diese Konzentration in etwa konstant zu lassen, um eine hinreichende Oxidations- oder Erosionsbeständigkeit zu gewährleisten. Auch andere Gradienten sind im Rahmen gewisser Grenzen ohne weiteres möglich, wobei die Verfahrensvariablen im einzelnen empirisch ermittelt werden können.

Zur Ermittlung der empirischen Werte müssen unter anderem die thermodynamischen Eigenschaften der Metalle bzw. der Mehrkomponentengemische berücksichtigt werden. Wie bereits oben erwähnt, ist die Konzentrationsverteilung in der Schicht im wesentlichen abhängig von der Ionisierung der Einzelmetalle. Dabei kann davon ausgegangen werden, daß in der Regel bei der Verdampfung aus einer Lichtbogenquelle der Ionenanteil von Metallen mit hohem Schmelzpunkt höher ist als der von Metallen mit niedrigem Schmelzpunkt. In der Tabelle sind dazu verschiedene ausgewählte Metalle mit ihren Schmelzpunkten, den Erosionsraten und den zugehörigen Ionisierungsgraden zusammengestellt.

| Metall | Schmelzpunkt (°C) | Erosionsrate ($\times 10^{-4}$ g/°C) | Ionisierungsgrad |
|--------|-------------------|--------------------------------------|------------------|
| Cd | 321 | 6.55<br>6.2 | 15 %<br>12 - 15 % |
| Zn | 420 | 2.15<br>3.2 | 25 %<br>15 - 20 % |
| Mg | 650 | 0.36 | 80 - 100 % |
| Al | 661 | 1.2 | 50 - 60 % |
| Ag | 961 | 1.5<br>1.4 | 60 %<br>50 - 60 % |
| Cu | 1081 | 1.15<br>1.3 | 55 %<br>60 - 70 % |
| Ni | 1453 | 1 | 60 - 70 % |
| Fe | 1536 | 0.73 | 65 % |
| Ti | 1668 | 0.52 | 80 % |
| Cr | 1875 | 0.4 | 100 % |
| Mo | 2610 | 0.47 | 100 % |
| W | 3410 | 0.62 | 100 % |

TABELLE: Eigenschaften ausgewählter Metalle

Auch bei Auswahl anderer Metallkombinationen sollte sich daher die beschriebenen Schichten realisieren lassen. Bei weiteren Beispielen können als Mischnitride CrAlN-Schichten oder NbAlN-Schichten, mit variablen Konzentrationen abgeschieden werden.

Es ist somit die Möglichkeit gegeben, bei der Oberflächenvergütung von Werkzeugen gezielt die Vorteile unterschiedlicher Metalle oder Hartstoffe auszunutzen.

**Ansprüche**

1. Verfahren zur Herstellung von Mischnitrid-Schichten mit wenigstens zwei Metallen, insbesondere zur Beschichtung von extrem belasteten Werkzeugen und Produktkomponenten, wobei die Metalle einen deutlich unterschiedlichen Schmelzpunkt haben und wobei die Herstellung der Schichten durch Verdampfen von Kathoden aus vorgegebenen Ausgangslegierungen der Metalle im Lichtbogen unter gleichzeitiger Zuführung von Stickstoff als Reaktionsgas und durch Kondensieren auf einem Substrat erfolgt, **dadurch gekennzeichnet,** daß beim Verdampfen der Ausgangslegierung eine variable Spannung an das Substrat angelegt und in Abhängigkeit von der Schichtdicke auf dem Substrat verändert wird, wodurch die Konzentration der Metalle über die Schichtdicke variiert.

2. Verfahren nach Anspruch 1, **dadurch gekennzeichnet,** daß die Spannung am Substrat zwischen Null und −400 V verändert wird.

3. Verfahren nach Anspruch 1, **dadurch gekennzeichnet,** daß die Spannung kontinuierlich verändert wird.

4. Verfahren nach Anspruch 1, **dadurch gekennzeichnet,** daß die Spannung am Substrat stufenweise verändert wird.

5. Verfahren nach Anspruch 1, wobei die Kathode aus einer TiAl-Legierung definierter Konzentration besteht, **dadurch gekennzeichnet,** daß die Aluminium-konzentration der Ausgangslegierung höher als die auf dem Substrat maximal erwünschte Konzentration vorgegeben wird.

6. Verfahren nach Anspruch 5, **dadurch gekennzeichnet,** daß die Aluminiumkonzentration der Schicht durch die Spannung am Substrat quantitativ vorgebbar ist.

7. Verfahren nach Anspruch 5 und 6, **dadurch gekennzeichnet,** daß zwei Materialquellen mit unterschiedlichen Aluminiumgehalten verwendet werden.

8. Verfahren nach Anspruch 1, **dadurch gekennzeichnet,** daß durch sprungweise Änderung der Spannung am Substrat Mischnitrid-Schichten mit sandwichartigem Aufbau erzeugt werden.

9. Verfahren nach Anspruch 1, **dadurch gekennzeichnet,** daß die Anreicherung der hochschmelzenden Metalle auf dem Substrat durch die Spannung als Saugspannung für die im Lichtbogen erzeugten Metallionen bewirkt wird.

10. Mischnitrid-Schicht, die nach Anspruch 1 oder einem der Ansprüche 2 bis 9 hergestellt ist, wobei die Schicht die Konstitution $Ti_xAl_{1-x}N$ mit Titan als Metall mit hohem Schmelzpunkt und Aluminium als Metall mit niedrigem Schmelzpunkt hat, **dadurch gekennzeichnet,** daß die Konzentration von Aluminium über die Schichtdicke zwischen 5% und 60%, bezogen auf den Maximalwert, variiert.

11. Mischnitrid-Schicht nach Anspruch 10, **dadurch gekennzeichnet,** daß die Aluminiumkonzentration über die Schichtdicke von 30 Gew.% auf 25 Gew.% abnimmt.

12. Mischnitrid-Schicht nach Anspruch 10, **dadurch gekennzeichnet,** daß die Aluminiumkonzentration über die Schichtdicke von 15 Gew.% auf 10 Gew.% abnimmt.

13. Mischnitrid-Schicht nach Anspruch 10, **dadurch gekennzeichnet,** daß die Aluminiumkonzentration über die Schichtdicke von 5 Gew.% auf 2 Gew.% abnimmt.

14. Mischnitrid-Schicht, die nach Anspruch 1 oder einem der Ansprüche 2 bis 9 hergestellt ist, wobei die Schicht die Konstitution $Ti_xAl_{1-(x+y)}V_yN$ mit Titan und Vanadium als Metalle mit hohem Schmelzpunkt und Aluminium als Metall mit niedrigem Schmelzpunkt hat, **dadurch gekennzeichnet,** daß die Konzentration von Aluminium über die Schichtdicke zwischen 5% und 60%, bezogen auf den Maximalwert variiert.

15. Mischnitrid-Schicht nach Anspruch 14, **dadurch gekennzeichnet,** daß der relative Vanadium-Anteil über die Schichtdicke stärker als der relative Titan-Anteil zunimmt.

16. Mischnitrid-Schicht nach Anspruch 14, **dadurch gekennzeichnet,** daß die Vanadium-Konzentration über die Schichtdicke zwischen 12% und 50%, bezogen auf den Minimalwert, variiert.

17. Mischnitrid-Schicht nach Anspruch 14 und 16, **dadurch gekennzeichnet,** daß die Aluminiumkonzentration über die Schichtdicke von etwa 5 Gew.% auf etwa 1,5 Gew.% abnimmt und die Vanadium-Konzentration von etwa 4% auf 6% zunimmt.

## Claims

1. Method for producing mixed nitride layers with at least two metals, in particular for coating tools and product components which are subject to extreme stress, where the metals have markedly differing melting points and wherein the layers are produced by the vaporization of cathodes made of prescribed starting alloys of metals in an electric arc, with the simultaneous supply of nitrogen as the reaction gas, and by condensation on a substrate, characterised in that during vaporization of the starting alloy, a variable voltage is applied to the substrate and is varied in dependence on the layer thickness on the substrate, causing the concentration of the metals to be varied over the layer thickness.

2. Method according to claim 1, characterised in that the voltage at the substrate is varied between zero and −400 V.

3. Method according to claim 1, characterised in that the voltage is varied continuously.

4. Method according to claim 1, characterised in that the voltage at the substrate is varied incrementally.

5. Method according to claim 1, wherein the cathode consists of a TiAl alloy of defined concentration, characterised in that the aluminium concentration of the starting alloy is predetermined higher than the maximum desired concentration on the substrate.

6. Method according to claim 5, characterised in that the aluminium concentration of the layer can be quantitively predetermined by the voltage at the substrate.

7. Method according to claim 5 and 6, characterised in that two material sources with different aluminium contents are used.

8. Method according to claim 1, characterised in that mixed nitride layers with a sandwich-like structure are produced by suddenly changing the voltage at the substrate.

9. Method according to claim 1, characterised in that the enrichment of the high-melting point metals on the substrate is effected by the voltage as the draining voltage for the metal ions produced in the electric arc.

10. Mixed nitride layer, produced according to claim 1 or one of claims 2 to 9, wherein the layer has the constitution $Ti_xAl_{1-x}N$ with titanium as the metal with the high melting point and aluminium as the metal with the low melting point, characterised in that the concentration of aluminium over the layer thickness varies between 5% and 60%, related to the maximum value.

11. Mixed nitride layer according to claim 10, characterised in that the aluminium concentration over the layer thickness decreases from 30% by w. to 25% by w.

12. Mixed nitride layer according to claim 10, chracterised in that the aluminium concentration over the layer thickness decreases from 15% by w. to 10% by w.

13. Mixed nitride layer according to claim 10, characterised in that the aluminium concentration over the layer thickness decreases from 5% by w. to 2% by w.

14. Mixed nitride layer, produced according to claim 1 or one of claims 2 to 9, wherein the layer has the constitution $Ti_xAl_{1-(x+y)}V_y$ N with titanium and vanadium as the metals with a high melting point and aluminium the metal with a low melting point, characterised in that the concentration of aluminium over the layer thickness varies between 5% and 60%, related to the maximum value.

15. Mixed nitride layer according to claim 14, characterised in that the relative vanadium proportion over the layer thickness increases more than the relative titanium proportion.

16. Mixed nitride layer according to claim 14, characterised in that the vanadium concentration over the layer thickness varies between 12% and 50%, related to the minimum value.

17. Mixed nitride layer according to claim 14 and 16, characterised in that the aluminium concentration over the layer thickness decreases from approximately 5% by w. to approximately 1.5% by w. and the vanadium concentration increases from approximately 4% to 6%.


## Revendications

1. Procédé de fabrication de couches de nitrures mixtes ayant au moins deux métaux, notamment pour revêtir des outils soumis à des contraintes extrêmes et des constituants de produit, les métaux ayant des points de fusion nettement différents et la fabrication des couches s'effectuant par vaporisation de cathodes, en alliages de départ prescrits des métaux, à l'arc électrique, avec envoi simultané d'azote servant de gaz réactif et par condensation sur un substrat, caractérisé en ce qu'il consiste à appliquer, lors de la vaporisation de l'alliage de départ, une tension variable au substrat et à la modifier en fonction de l'épaisseur de la couche sur le substrat, de manière à faire varier la concentration des métaux sur l'épaisseur de la couche.

2. Procédé suivant la revendication 1, caractérisé en ce qu'il consiste à faire varier la tension sur le substrat entre 0 et –400 V.

3. Procédé suivant la revendication 1, caractérisé en ce qu'il consiste à faire varier la tension en continu.

4. Procédé suivant la revendication 1, caractérisé en ce qu'il consiste à faire varier la tension sur le substrat par palier.

5. Procédé suivant la revendication 1, dans lequel la cathode est en un alliage de TiAl d'une concentration définie, caractérisé en ce que la concentration d'aluminium de l'alliage de départ est plus grande que la concentration maximum souhaitée sur le substrat.

6. Procédé suivant la revendication 5, caractérisé en ce que la concentration d'aluminium de la couche peut être prescrite quantitativement par la tension appliquée au substrat.

7. Procédé suivant la revendication 5 ou 6, caractérisé en ce qu'il consiste à utiliser deux sources de matériaux ayant des teneurs en aluminium qui sont différentes.

8. Procédé suivant la revendication 1, caractérisé en ce qu'il consiste à produire des couches de nitrures mixtes sur le substrat à structure stratifiée, en faisant varier brusquement la tension.

9. Procédé suivant la revendication 1, caractérisé en ce qu'il consiste à provoquer l'enrichissement en le métal à point de fusion élevé sur le substrat par la tension servant de tension d'accélération pour les ions métalliques produits dans l'arc électrique.

10. Couche de nitrure mixte, qui est fabriquée suivant la revendication 1 ou l'une des revendications 2 à 9, la couche ayant la constitution $Ti_xAl_{1-x}N$, le titane étant le métal ayant le point de fusion élevé et l'aluminium le métal ayant le point de fusion bas, caractérisée en ce que la concentration de l'aluminium varie sur l'épaisseur de la couche entre 5% et 60% par rapport à la valeur maximum.

11. Couche de nitrure mixte suivant la revendication 10, caractérisée en ce que la concentration d'aluminium diminue sur l'épaisseur de la couche de 30% à 25% en poids.

12. Couche de nitrure mixte suivant la revendication 10, caractérisée en ce que la concentration d'aluminium diminue sur la hauteur de la couche de 15% en poids à 10% en poids.

13. Couche de nitrure mixte suivant la revendication 10, caractérisée en ce que la concentration d'aluminium diminue sur l'épaisseur de la couche de 5% en poids à 2% en poids.

14. Couche de nitrure mixte, qui est fabriquée suivant la revendication 1 ou l'une des revendications 2 à 9, la couche ayant la constitution $Ti_xAl_{1-(x+y)}V_y$ N, le titane et le vanadium étant les métaux à point de fusion

EP 0 284 854 B1

élevé et l'aluminium le métal à bas point de fusion, caractérisée en ce que la concentration de l'aluminium sur l'épaisseur de la couche varie entre 5% et 60% par rapport à la valeur maximum.

15. Couche de nitrure mixte suivant la revendication 14, caractérisée en ce que la proportion relative de vanadium sur l'épaisseur de la couche croît d'une manière plus forte que la proportion relative de titane.

16. Couche de nitrure mixte suivant la revendication 14, caractérisée en ce que la concentration de vanadium sur l'épaisseur de la couche varie entre 12% et 50% par rapport à la valeur minimum.

17. Couche de nitrure mixte suivant la revendication 14 ou 16, caractérisée en ce que la concentration d'aluminium sur l'épaisseur de la couche diminue de 5% en poids environ à 1,5% en poids environ et la concentration de vanadium augmente de 4% à 6% environ.

FIG 1

FIG 2

FIG 3

FIG 4